# EUROPÄISCHE PATENTSCHRIFT

(11) **EP 3 172 841 B1**
(45) Veröffentlichungstag und Bekanntmachung des Hinweises auf die Patenterteilung: **05.12.2018**
(21) Anmeldenummer: 15736815.0
(22) Anmeldetag: 08.07.2015
(51) Int. Cl.: H03K 17/96, B60K 37/06, H03K 17/965, H01H 23/30

(54) **BEDIENEINHEIT FÜR EIN ELEKTRISCHES GERÄT, INSBESONDERE FÜR EINE FAHRZEUGKOMPONENTE**
CONTROL UNIT FOR AN ELECTRICAL APPARATUS, IN PARTICULAR FOR A VEHICLE COMPONENT
UNITÉ DE COMMANDE POUR UN APPAREIL ÉLECTRIQUE, EN PARTICULIER POUR UN COMPOSANT DE VÉHICULE

(30) Priorität: 22.07.2014 DE 102014214224
(43) Veröffentlichungstag der Anmeldung: 31.05.2017
(73) Patentinhaber: Behr-Hella Thermocontrol GmbH, 70469 Stuttgart (DE)
(72) Erfinder: BESCHNITT, Alexander, 59557 Lippstadt (DE); STEINKAMP, Michael, 59557 Lippstadt (DE)
(74) Vertreter: dompatent von Kreisler Selting Werner - Partnerschaft von Patent- und Rechtsanwälten mbB
(86) Internationale Anmeldenummer: PCT/EP2015/065573
(87) Internationale Veröffentlichungsnummer: WO 2016/012241

(56) Entgegenhaltungen:
- EP-A1- 1 988 441
- WO-A1-2013/153048
- DE-B3-102012 221 107

## Beschreibung

Die Erfindung betrifft eine Bedieneinheit für ein elektrisches Gerät, bei dem es sich insbesondere um eine Fahrzeugkomponente z.B. eine Heizungs-, Lüftungs- oder Klimaanlage handeln kann.

Bedieneinheiten für elektrische Geräte sind in den unterschiedlichsten Ausgestaltungen bekannt. Insbesondere im Kfz-Bereich haben sich in jüngster Vergangenheit Bedienkonzepte durchgesetzt, bei denen ein leistenförmiges Bedienelement mit mehreren Bedienfeldern zur Auslösung unterschiedlicher Gerätefunktionen bei manueller Betätigung bewegbar gelagert ist, wobei eine entsprechende Sensorik die Anlageposition des Fingers einer Hand auf der Bedienleiste erkennt und damit ermittelbar ist, welche Gerätefunktion ausgewählt worden ist. Bei der Sensorik handelt es sich beispielsweise um Näherungs- bzw. Berührungssensoren, die zumeist kapazitiv arbeiten. Wenn z.B. aus Design-Gründen die gesamte Bedienleiste eine metallische Bedienfläche aufweist oder die Betätigung beim Tragen von Handschuhen erfolgen kann, so lässt sich eine kapazitive Sensorik in der Bedienleiste nicht verwenden. Es existieren andere Konzepte, bei denen durch Biegekraft- oder Abstandssensoriken an verschiedenen Stellen der Aufhängung der Bedienleiste anhand von Differenzsignalen ermittelt werden kann, an welcher Position sich der Finger einer Hand bei Betätigung der Bedienleiste befindet, wie dies z. B. in WO-A-2013/153048 beschrieben ist. Die Bedienleiste der aus dieser Schrift bekannten Bedieneinheit ist von einem Trägerelement quasi starr gehalten, wobei auf die Bedienleiste bei manueller Betätigung Kippmomente wirken, und zwar bezogen auf eine parallel zur Bedienleistenerstreckung verlaufende Achse.

Aus DE-B-10 2012 221 107 ist eine Bedieneinheit für ein elektrisches Gerät bekannt, wobei die Bedieneinheit ein Gehäuse mit einer über die Vorderwand des Gehäuses vorstehenden Bedienleiste aufweist, die eine Bedienfläche mit einer Vielzahl von in Längserstreckung der Bedienleiste nebeneinander und zwischen zwei Enden der Bedienleiste angeordnete Bedienfelder zum Auslösen unterschiedlicher Gerätefunktionen aufweist. Die Bedienleiste ist an einem im Gehäuse angeordneten Trägerelement um eine quer zur Längserstreckung der Bedienleiste verlaufende Achse gelagert, wobei das Trägerelement in mindestens einer Richtung aus einer Ruheposition, in die das Trägerelement elastisch vorgespannt ist, um eine parallel zur Längserstreckung der Bedienachse verlaufende Achse in eine Betätigungsposition bewegbar ist. Ferner weist die bekannte Bedieneinheit einen Positionssensor zur Erfassung der Position des Trägerelements bei einer Betätigung der Bedienleiste und zwei Erfassungssensoren zur Erfassung einer Position bei Betätigung der Bedienleiste durch manuelles Andrücken gegen ein Bedienfeld der Bedienleiste auf. Die Erfassungssensoren erfassen eine Bewegung der Enden der Bedienleiste bei Betätigung derselben. Schließlich ist die bekannte Bedieneinheit versehen mit einer Auswerte- und Ansteuereinheit zum Empfang der Signale des Positionssensors und der Erfassungssensoren und zur anhand der Signale der Erfassungssensoren erfolgenden Ermittlung desjenigen Bedienfeldes, auf den bei manueller Betätigung der Bedienleiste der Finger einer Hand mit einer zur Einnahme der Betätigungsposition des Trägerelements erforderlichen Betätigungskraft anliegt, und zur Auslösung der dem so ermittelten Bedienfeld zugeordneten Gerätefunktion.

Aufgabe der Erfindung ist es, eine Bedieneinheit für ein elektrisches Gerät zu schaffen, bei dem sich die Position des Fingers bei Betätigung einer Bedienleiste der Bedieneinheit mit großer Zuverlässigkeit und sicher detektieren lässt.

Zur Lösung dieser Aufgabe wird mit der Erfindung eine Bedieneinheit für ein elektrisches Gerät, insbesondere für eine Fahrzeugkomponente wie z.B. eine Heizungs-, Lüftungs- und/oder Klimaanlage vorgeschlagen, wobei die Bedieneinheit versehen ist mit den Merkmalen des Anspruchs 1. Einzelne Ausgestaltungen der Erfindung ergeben sich aus den Unteransprüchen.

Die erfindungsgemäße Bedieneinheit weist eine Bedienleiste auf, die an der Vorderwand eines Gehäuses angeordnet ist. Dabei ist die Bedienleiste, bezogen auf ihre Längserstreckung, etwa in der Mitte kippbar bzw. um ihre Mitte biegbar gelagert. Mit anderen Worten ist die Bedienleiste mit einem im Gehäuse angeordneten Trägerelement über eine Kippachse oder Torsionsachse verbunden. Die beidseitig dieser Achse angeordneten Enden der Bedienleiste sind dabei im Wesentlichen frei bewegbar. Die Bedienleiste weist mehrere Bedienfelder auf, die zusammen die Bedienfläche der Bedienleiste bilden. Jedem Bedienfeld ist dabei die Auslösung einer Gerätefunktion zugeordnet. Wird nun beispielsweise mit dem Finger einer Hand gegen eines der Bedienfelder der Bedienleiste gedrückt oder wird die Bedienleiste im Bereich dieses Bedienfeldes nach oben "gezogen", ist das auf die Bedienleiste wirkende Dreh- bzw. Biegemoment abhängig von der Entfernung des betreffenden Bedienfeldes, an dem der Finger einer Hand angreift. Durch Kipperfassungssensoren werden potentielle Bewegungen der Bedienleiste an deren Enden bzw. die an den Enden der Bedienleiste wirkenden Momente erfasst. Insoweit ist mit dem Begriff "Kipperfassungssensor" nicht notwendigerweise gemeint, dass hier eine Bewegung eines Endes der Bedienleiste oder eine Verkippung der Bedienleiste detektiert wird; vielmehr wird detektiert, welche Momente auf die Bedienleiste bei deren Betätigung wirken. Nichtsdestotrotz ist es aber auch möglich, eine Kippbewegung der Bedienleiste zu detektieren, wenn diese hierfür ausgelegt ist.

Damit die Fingerauflageposition auf dem Bedienfeld der Bedienleiste bei deren Betätigung zuverlässig detektiert werden kann, muss die Auswertung der Signale der Kipperfassungssensoren in dem Augenblick erfolgen, in dem auf die Bedienleiste eine vorgegebene Mindestbetätigungskraft einwirkt. Dies wird nach der Erfindung dadurch realisiert, dass die Einheit aus Trägerelement und Bedienleiste um eine Schwenkachse schwenkbar ist, und zwar aus einer Ruheposition heraus in mindestens eine Schwenkposition bzw. in eine in mindestens einer Schwenkrichtung liegenden Schwenkposition. Das Trägerelement ist mechanisch in die Ruheposition vorgespannt. Um aus der Ruheposition in die mindestens eine Schwenkposition zu gelangen, bedarf es der Aufbringung einer bestimmten Mindestbetätigungskraft auf die Bedienleiste. Die Schwenkachse verläuft quer zur Kippachse. Wird nun durch einen Schwenkpositionssensor die Einnahme der Schwenkposition des Trägerelements erkannt, so wird über eine Auswerte- und Ansteuereinheit in diesem Augenblick die auf die Bedienleiste wirkenden Drehmomente bzw. Kippmomente oder auch Kippbewegungen erfasst, und zwar über die Kipperfassungssensoren. Je größer ein von einem Kipperfassungssensor detektiertes Drehmoment bzw. je größer eine von einem Kipperfassungssensor erfasste Verkippung der Bedienleiste ist, desto weiter entfernt von der Kippachse muss der Finger der Hand an der Bedienleiste anliegen. Auf diese Weise ist also die Ortung des Fingerauflagepunktes auf der Bedienfläche der Bedienleiste möglich.

Die vorstehende Beschreibung der Erfindung erfolgte unter dem Aspekt, dass die Kippachse zwischen den Enden der Bedienleiste angeordnet ist, und zwar im Wesentlichen in der Mitte der Bedienleiste. Es ist aber ebenfalls denkbar, dass die Bedienleiste einseitig kippbar, also beispielsweise an einem ihrer Enden kippbar gelagert ist. Dann verhält sich die Bedienleiste im Wesentlichen wie ein Biegebalken, der einseitig eingespannt ist.

Die Bedienleiste kann aus einem Material gefertigt sein (im Regelfall Kunststoff), so dass sie sich bei einer manuellen Betätigung, d.h. beim Andrücken mit dem Finger einer Hand geringfügig elastisch verformt, was aber im Idealfall optisch nicht zu erkennen ist. Andere Materialien für die Bedienleiste sind ebenfalls denkbar. Zweckmäßig ist es, wenn die Bedienleiste zumindest im Bereich ihres Bedienfeldes oberflächenbeschichtet und somit veredelt ist. Dann hat die gesamte Bedienleiste die Anmutung einer hochwertigen Leiste, was je nach den Designanforderungen von Vorteil sein kann.

Entscheidend für die Erfindung aber ist die Aufhängung (Anbindung) der Bedienleiste an dem Trägerelement; diese Aufhängung/Anbindung ist elastisch verformbar und kann als Torsionsfeder o.dgl. Torsionselement bezeichnet werden. Wenn eine idealisiert steife Bedienleiste an einem Torsionselement aufgehängt wird, lässt dieses einen gewissen Freiheitsgrad (nämlich Rotation) zu, so dass das Torsionselement idealisiert als Drehlager aufgefasst werden kann. Auf Grund der ideal steifen Bedienleiste findet keine elastische Verformung in der Leiste statt. Insoweit gilt der Zusammenhang, dass je größer der Hebel (welches Bedienfeld wird gedrückt?) ist, desto größer jedoch das Torsionsmoment des Torsionselements ist. Idealisiert entsteht somit je nach Hebellänge an den Kipperfassungssensoren, die beabstandet von dem Torsionselement angeordnet sind, eine unterschiedliche Auflagerkraft/Verschiebung.

Wenn die Bedienleiste nun z.B. aus Kunststoff gefertigt und damit nicht idealisiert steif ist, erhält man zusätzlich eine gewisse Eigenelastizität der Bedienleiste. Diese ist jedoch für die Kipperfassungssensoren nicht ausschlaggebend. Einzig die über das Torsionselement gegebene Tordierung des Torsionselements, was eine Rotation der Bedienleiste ermöglicht, ist erfindungsgemäß von Interesse. Wünschenswert insoweit ist eine möglichst hohe Steifigkeit der Bedienleiste, um das Moment zum größten Teil an die Positionen der Kipperfassungssensoren zu übertragen statt in eine eigene Deformation der Bedienleiste zu transformieren, mit der Folge, somit geringere Signale an den Sensoren zu erzeugen.

Der Grundgedanke des erfindungsgemäßen Konzepts ist es also, grundsätzlich nicht auf eine Durchbiegung der Bedienleiste angewiesen zu sein, wobei allerdings eine solche Eigenelastizität der Bedienleiste nichtsdestotrotz toleriert werden kann.

Das erfindungsgemäße Konzept erlaubt die sehr exakte Fingerauflageposition auf einer Bedienleiste mit mehreren Bedienfeldern. Hierzu ist keinerlei Näherungssensor in der Bedienleiste selbst erforderlich. Derartige Sensoriken basieren zumeist auf kapazitiven Konzepten, lassen sich also bei einer durchgehend metallisierten Bedienoberfläche nicht realisieren. Außerdem verbietet sich bei kapazitiven Näherungssensoriken die Bedienung mittels einer Hand, die mit einem Handschuh versehen ist. Das erfindungsgemäße Konzept lebt von dem Drehmoment der Bedienleiste, die ein Torsionsmoment in einer Torsionsachse erzeugt. Die Torsionsachse lässt diesen Freiheitsgrad zu und somit auch die Entstehung von Drehmomenten an den Enden der Bedienleiste. Somit besteht eine Unabhängigkeit zwischen der Durchbiegung der Bedienleiste gegenüber dem Torsionsmoment in der Torsionsachse. Das Torsionselement tordiert und lässt die Rotation der Bedienleiste zu, wie bei einer ideal steifen Wippe, die auf Grund der Torsionsachse rotieren kann.

Anhand einer Mustererkennung (nämlich anhand der von den beiden Kipperfassungssensoren gelieferten Signale) wird auf die Position des Fingers auf der Bedienleiste geschlossen. Es sind weniger Sensoren als Bedienfelder erforderlich, was den sensortechnischen Aufwand reduziert.

Das erfindungsgemäße Konzept kann mit Force Sense/Force Feedback-Bediensystemen kombiniert werden. Diesbezüglich kann vorgesehen sein, dann, wenn eine Betätigung der Bedienleiste detektiert wird, diese in erzwungene mechanische Bewegungen zu versetzen, um auf diese Weise der Bedienperson eine haptische/taktile Betätigungsrückmeldung zu geben. Der mindestens eine Schwenkpositionssensor dient dabei der Erkennung der Betätigung, ist also insoweit als Force Sense Sensor aufzufassen. Ein Force Sense Sensor könnte aber ebenso gut eine Mindestkraft detektieren, die auf die Bedienleiste und/oder auf das Trägerelement bei einer Betätigung einwirkt.

Das erfindungsgemäße Konzept arbeitet hinsichtlich der Ortserkennung des Fingers unabhängig von der Steifigkeit der Bedienleiste (siehe oben). Das erfindungsgemäße Prinzip funktioniert unabhängig von der Ausführung der Bedienfläche der Bedienleiste (elektrisch leitfähig/elektrisch nicht leitfähig). Eine Handschuhbedienung ist ohne Probleme möglich. Die Detektion einer Fehlbetätigung (Betätigung der Bedienleiste zwischen zwei Bedienfeldern bzw. durch gleichzeitige Betätigung zweier Bedienfelder, die symmetrisch zur Kippachse sind,) ist mit der erfindungsgemäßen Konstruktion ebenso möglich.

In vorteilhafter Weiterbildung der Erfindung kann vorgesehen sein, dass die Bedienleiste an ihren Enden mittels Biegestegen mit dem Trägerelement verbunden ist und dass die Kipperfassungssensoren eine Verbiegung der Biegestege beim Verkippen der Bedienleiste um die Kippachse detektieren.

Zweckmäßig kann es ferner sein, wenn die Kippachse als elastische Torsionsachse ausgebildet ist.

Um bei beispielsweise in der Mitte kippbar/tordierbar angebundener Bedienleiste erkennen zu können, wenn zwei zu unterschiedlichen Seiten der Kippachse angeordnete Bedienfelder mit jeweils gleichem Abstand zur Kippachse gleichzeitig bedient werden, ist es von Vorteil, einen Kippachsensensor zur Erfassung einer Bewegung der Kippachse in einer sowohl zur Kippachse selbst als auch zur Schwenkachse senkrecht verlaufenden Normal-Bewegungsrichtung vorzusehen. Bei dieser Art der Fehlbetätigung der Bedienleiste würden die beiden Kipperfassungssensoren im Wesentlichen gleich große Signale liefern. Ohne den Sensor, der Biegemomente längs der Kippachse detektiert, also ohne den Kippachsensensor, würde man also die Fehlbetätigung nicht detektieren können. Durch das in diesem Fall vom Kippachsensensor zusätzlich gelieferte Signal kann also anhand des Ansprechens dieses Kippachsensensors die Fehlbetätigung erkannt werden. Wird hingegen dasjenige Bedienfeld betätigt, das im Bereich der Kippachse angeordnet ist und zu dem die Kippachse idealerweise mittig angeordnet ist, so liefert der Kippachsensensor zusammen mit den untereinander im Wesentlichen gleich großen Signalen der Kipperfassungssensoren ein Signalmuster, aus dem sich schließen lässt, dass das betreffende Bedienfeld im Bereich der Kippachse betätigt worden ist.

Für die Erfassung eines längs der Kippachse wirkenden Biegemoments ist es von Vorteil, wenn die Kippachse hinsichtlich in Normal-Bewegungsrichtung wirkenden Biegemomenten biegesteif ist. Dies gilt dann ganz entsprechend auch für den Fall, dass die Kippachse als Torsionsachse ausgebildet ist.

In weiterer vorteilhafter Ausgestaltung der Erfindung kann vorgesehen sein, dass die Torsionsachse als Verbindungssteg ausgebildet ist, der wie die Biegestege zu einer gemeinsamen Seite von einem Quersteg absteht, wobei die Biegestege und der Verbindungssteg an dem Trägerelement fixiert sind und die Bedienleiste tragen.

Schließlich kann es von Vorteil sein, wenn der Verbindungssteg auf Grund seiner Geometrie, seines Materials und/oder der Position seiner Anbindung an das Trägerelement und/oder an die Bedienleiste steifer ausgebildet ist als die Biegestege und/oder wenn z.B. bei gleicher Geometrie und gleichem Material des Verbindungsstegs sowie der Biegestege der Verbindungssteg kürzer ist als die Biegestege und/oder eine kürzere freie Biegelänge aufweist als die Biegestege, und zwar insbesondere dadurch, dass der Verbindungssteg an einer ersten Anbindungsstelle von dem Trägerelement und die Biegestege an einer zweiten Anbindungsstelle von dem Trägerelement abstehen, wobei die zweiten Anbindungsstellen von der Bedienleiste weiter beabstandet sind als die erste Anbindungsstelle.

Wie bereits oben erwähnt, ist das Trägerelement schwenkbar gelagert. Um an der Bedienleiste in zwei entgegengesetzten Richtungen angreifen zu können, ist es von Vorteil, wenn das Trägerelement aus der Ruheposition in zwei entgegengesetzten Schwenkrichtungen und damit in zwei entgegengesetzte Schwenkpositionen schwenkbar ist, wobei der Schwenkpositionssensor die jeweils eingenommene Schwenkposition erfasst, oder dass zwei Schwenkpositionssensoren zur Erfassung jeweils einer anderen der beiden Schwenkpositionen vorgesehen sind.

Desweiteren kann mit Vorteil vorgesehen sein, dass jeder Kipperfassungssensor eine Bewegung des betreffenden Endes der Bedienleiste und/oder ein auf das betreffende Ende der Bedienleiste wirkendes Moment in jeder von zwei entgegengesetzten Bewegungsrichtungen erfasst. Hierbei kann es ferner zweckmäßig sein, wenn jeder Kipperfassungssensor in einer Ruheposition der Bedienleiste, in der die Bedienleiste nicht betätigt ist, eine Vorspannung des betreffenden Biegesteges erfasst und dass die Bewegungsrichtung eines Endes der Bedienleiste bei deren Betätigung anhand einer Vergrößerung oder einer Verkleinerung des Signals des Kipperfassungssensors, das dieser bei in Ruheposition befindlicher Bedienleiste ausgibt, detektierbar ist.

In weiterer zweckmäßiger Ausgestaltung der Erfindung ist es möglich, dass die Sensoren kapazitiv, induktiv, ohmsch oder optisch arbeiten oder als Endschalter ausgebildet sind.

Wie bereits oben angesprochen, ist es von Vorteil, wenn die Kipperfassungssensoren eine Betätigung der Bedienleiste sowohl bei einer oberseitigen als auch bei einer unterseitigen Anlage des Fingers einer Hand an der Bedienleiste erfassen.

Die Erfindung wird nachfolgend anhand von Ausführungsbeispielen sowie unter Bezugnahme auf die Zeichnung näher erläutert. Im Einzelnen zeigen dabei:
- Fig. 1: eine perspektivische Vorderansicht auf eine Bedieneinheit gemäß einem Ausführungsbeispiel der Erfindung,
- Fig. 2: eine perspektivische Ansicht auf die "aufgeschnittene" Bedieneinheit gemäß Fig. 1 zur Verdeutlichung der Schwenklagerung und Anbindung der Bedienleiste an ein im Gehäuse schwenkbar gelagertes Trägerelement,
- Fig. 3: eine Draufsicht auf das aufgeschnittene Gehäuse gemäß dem Pfeil III der Fig. 2,
- Fig. 4: eine Ansicht ähnlich der gemäß Fig. 3 jedoch bei alternativ ausgebildeter Kippachse der Bedienleiste,
- Fig. 5: eine perspektivische Ansicht der Kombination aus Trägerelement und Bedienleiste gemäß dem Ausführungsbeispiel nach Fig. 4,
- Fig. 6: eine alternative Ausgestaltung der Kombination aus Trägerelement und Bedienleiste und
- Fig. 7: schematisch und durch graphische Elemente verdeutlicht die verschiedentliche Kombination von Signalhüben an den einzelnen Sensorelementen.

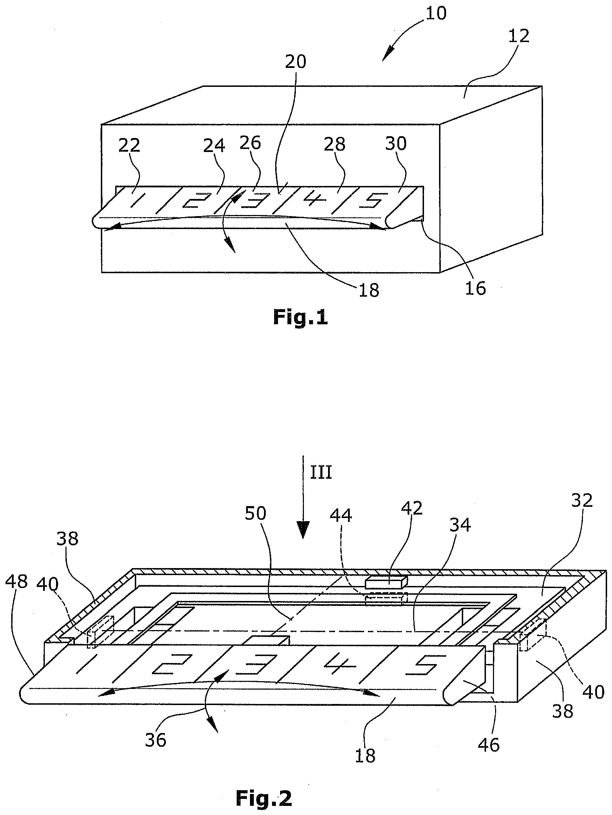

In Fig. 1 ist perspektivisch und in Vorderansicht eine vereinfachte Bedieneinheit 10 gezeigt. Die Bedieneinheit 10 weist ein Gehäuse 12 mit einer Vorderwand 14 auf, in der sich eine Aussparung 16 befindet. Durch die Aussparung 16 hindurch ragt eine Bedienleiste 18, die über die Vorderwand 14 übersteht. Die Bedienleiste 18 weist eine Bedienfläche 20 mit mehreren nebeneinander angeordneten Bedienfeldern 22,24,26,28 und 30 auf. Die Bedieneinheit 10 weist im Regelfall noch andere Bedienelemente und insbesondere auch Anzeigeelemente in Form von Displays oder anderen optischen Anzeigeelementen auf, auf die es im Rahmen der Erfindung aber nicht ankommt, weshalb diese hier nicht näher beschrieben werden und in den Figuren nicht gezeigt sind.

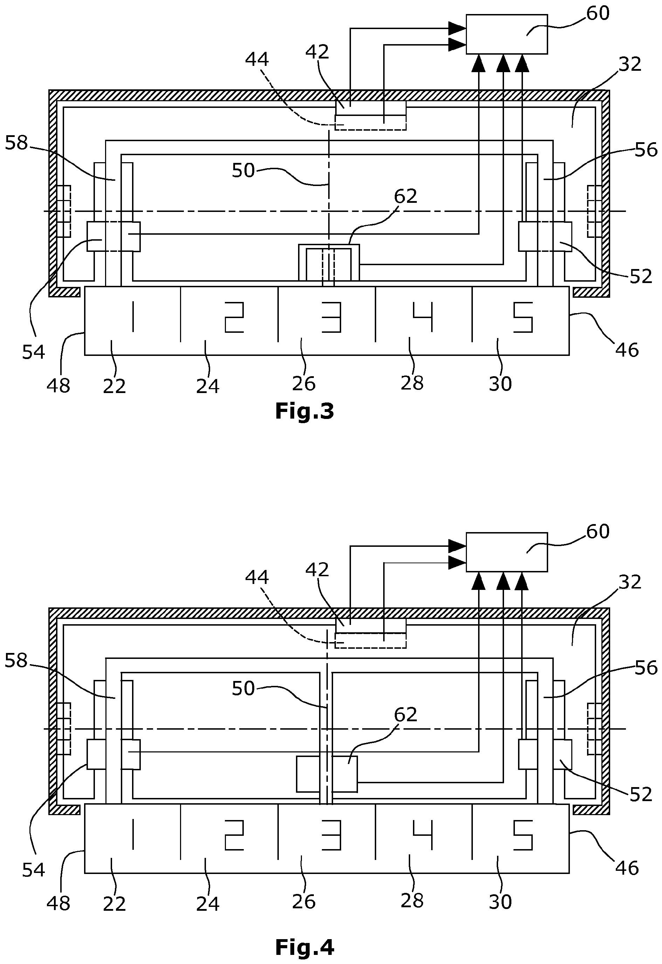

Wie insbesondere anhand der Fign. 2 und 3 zu erkennen ist, ist die Bedienleiste 18 mit einem Trägerelement 32 verbunden, das innerhalb des Gehäuses 12 angeordnet ist. Das Trägerelement 32 ist im Wesentlichen plattenförmig ausgebildet und ist um eine Schwenkachse 34 ausgehend von einer Ruheposition, in die das Trägerelement 32 mechanisch vorgespannt ist, in eine von zwei in entgegengesetzten Schwenkrichtungen liegende Schwenkpositionen verschwenkbar. Die beiden Schwenkrichtungen sind durch den Pfeil 36 angedeutet. Im Bereich der Seitenwände 38 des Gehäuses 12 befinden sich Schwenklagerböcke 40, an denen das Trägerelement 32 um die Schwenkachse 34 schwenkbar gelagert ist.

Die Einnahme einer der beiden Schwenkpositionen bei Betätigung der Bedienleiste 18 wird durch Schwenkpositionssensoren 42,44 detektiert, die in diesem Ausführungsbeispiel ebenfalls in dem Gehäuse 12 angeordnet sind (siehe Fig. 2).

Die Bedienleiste 18 weist zwei Enden 46,48 auf. In der Mitte zwischen diesen beiden Enden 46,48 ist die Bedienleiste 18 über eine Kippachse bzw. eine Torsionswelle 50 (z.B. Torsionsfeder) mit dem Trägerelement 32 verbunden. An den beiden Enden 46,48 ist die Bedienleiste 18 im Wesentlichen freiliegend. Dadurch wirken nun bei einer Betätigung der Bedienleiste 18 in Abhängigkeit von der Auflageposition des Fingers einer Hand unterschiedlich starke Drehmomente, die entweder zu einer unterschiedlich starken Verschwenkung oder aber Spannung innerhalb der Bedienleiste 18 führen. Dies wird detektiert durch zwei Kipperfassungssensoren 52,54, die auf die Enden 46,48 wirkende Biegemomente bzw. Bewegungen erfassen. In diesem Ausführungsbeispiel erfolgt dies durch Biegestege 56,58, die vom Trägerelement 32 abstehen. Diese Biegestege 56,58 wirken auf die Kipperfassungssensoren 52,54 ein, so dass der Grad der Verbiegung und auch die Richtung der Verbiegung der Biegestege 56,58 ein Maß für die Verformung bzw. die Biegemomente ist, die bei der Betätigung der Bedienleiste 18 auf diese wirken.

Wie in Fig. 3 gezeigt, sind die beiden Schwenkpositionssensoren 42,44 mit einer Auswerte- und Ansteuereinheit 60 verbunden. Mit dieser Auswerte- und Ansteuereinheit 60 sind auch die beiden Kipperfassungssensoren 52,54 verbunden. Zusätzlich kann ein weiterer Sensor 62 vorgesehen sein, der auf die Achse 50 wirkende Biegemomente bei Betätigung der Bedienleiste 18 erfasst.

Die Ortung des Auflagepunkts des Fingers einer Hand auf der Bedienleiste 18 bei deren Betätigung erfolgt anhand der Signale der Kipperfassungssensoren 52,54. Denn je weiter entfernt von der Achse 50 auf die Bedienleiste 18 die Betätigungskraft ausgeübt wird, desto größere Drehmomente wirken auf die Bedienleiste 18. Dabei muss sichergestellt werden, dass die Signale der Kipperfassungssensoren 52,54 in dem Augenblick ausgewertet werden, in dem eine wirksame Betätigung der Bedienleiste 18 erkannt wird. Die Ermittlung dieses Zeitpunkts gelingt durch die Schwenkpositionssensoren 42,44, die die Einnahme einer der beiden Schwenkpositionen detektieren. In diesem Augenblick werden dann die Signale der Kipperfassungssensoren 52,54 ausgewertet und somit anhand der Erkennung dieser Signalmuster auf das Bedienfeld geschlossen, auf den der Finger einer Hand bei Betätigung der Bedienleiste 18 aufliegt.

Durch den zusätzlichen Sensor 62 ist es nun möglich, Fehlbedienungen der Bedienleiste 18 zu erkennen. Wenn beispielsweise gleichzeitig auf die beiden außenliegenden Bedienfelder 22,30 gedrückt wird, so geben die beiden Kipperfassungssensoren 52,54 im Wesentlichen gleiche Signale aus. Theoretisch könnte dies aber auch bedeuten, dass der Finger der Hand auf dem mittleren Bedienfeld 26 aufliegt. Hier wird jetzt zusätzlich das Signal des Kippachsensensors 62 ausgewertet, der dann, wenn der Finger der Hand bei im Wesentlichen gleichen Signalen der Kipperfassungssensoren 52,54 auf dem mittleren Bedienfeld 26 aufliegt, ein anderes Signal ausgibt als in dem Fall, in dem zwei Finger gleichzeitig auf den außenliegenden Bedienfeldern 22,30 aufliegen.

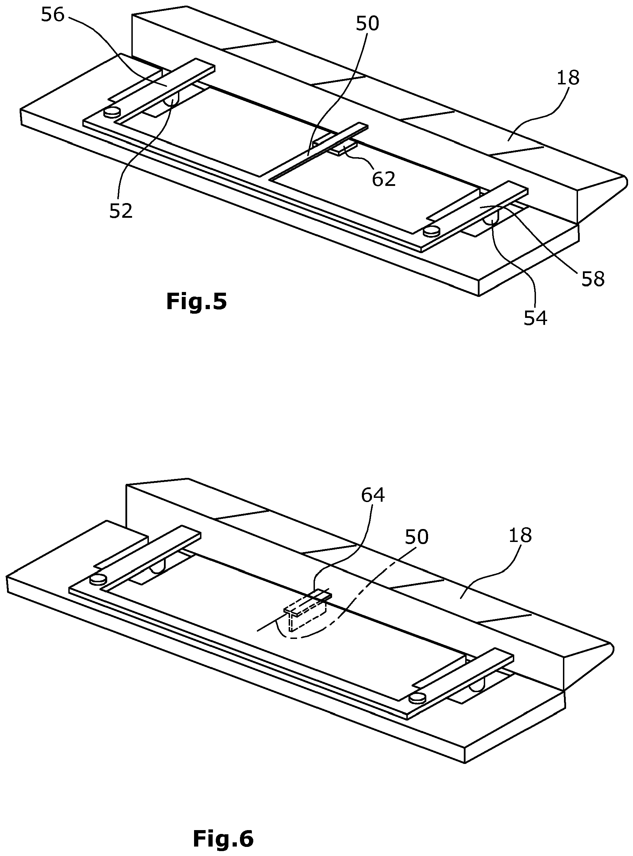

Fign. 4 und 5 zeigen eine alternative Ausgestaltung der Erfindung, bei der die Achse 50 als Torsionsfeder ausgebildet ist. Die übrigen Elemente der Bedieneinheit gemäß Fign. 4 und 5 sind identisch mit denjenigen der Bedieneinheit nach den Fign. 1 bis 3.

Fig. 6 schließlich zeigt noch ein weiteres Ausführungsbeispiel der Erfindung, bei der die Achse 50 als längs ihrer Erstreckung biegesteife Torsionsfeder 64 ausgebildet ist. Auch hier gilt, dass die anderen Bestandteile der Bedieneinheit dieses Ausführungsbeispiel identisch sind zu denjenigen der Bedieneinheit gemäß den Fign. 1 bis 3.

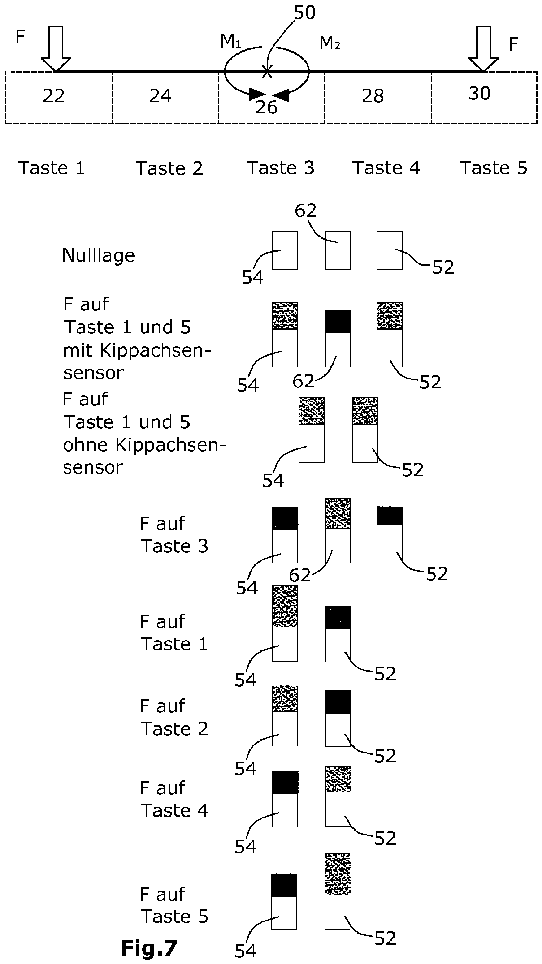

Fig. 7 zeigt schematisch nochmals die weiter oben beschriebene Situation, anhand der Signale der Kipperfassungssensoren 52,54 und des Kippachsensensors 62 auf den Ort der Fingerauflage auf der Bedienleiste 18 zu schließen. In Fig. 7 sind die Bedienfelder 22,24,26,28,30 zusätzlich noch mit "Taste 1" bis "Taste 5" bezeichnet. In der Situation, in der bei einer Fehlbedienung gleichzeitig auf die Tasten 1 und 5 (oder alternativ auf die Tasten 2 und 4) gedrückt wird, sensieren die beiden Kipperfassungssensoren 52,54 im Wesentlichen die gleichen Kräfte bzw. Momente, so dass ihre Signale im Wesentlichen gleich sind. Der Kippachsensensor 62 erfasst ebenfalls ein Signal, das aber geringer ist. Dadurch wird erkannt, dass eine Fehlbetätigung vorliegt.

Ohne diesen Kippachsensensor 62 würde man die Fehlbetätigung nicht erkennen können.

Wird dagegen ausschließlich die mittlere Taste 3 gedrückt, so ist das Signal des Kippachsensensors 62 größer als die Signale der beiden Kipperfassungssensoren 52,54, womit die Betätigung der Bedienleiste 18 durch Auflage des Fingers auf der Taste 3 erkannt wird.

Wird beispielsweise auf Taste 1 gedrückt, so ist das Signal des Kipperfassungssensors 54 größer als dasjenige des Kipperfassungssensors 52. Bei Betätigung der Taste 2 ist diesbezüglich immer noch ein Unterschied festzustellen, der aber geringer ist als im zuvor genannten Fall. Die Situation ist entsprechend umgekehrt bei Betätigung der Taste 4 bzw. 5.

### BEZUGSZEICHENLISTE

- 10: Bedieneinheit
- 12: Gehäuse
- 14: Vorderwand des Gehäuses
- 16: Aussparung in der Vorderwand
- 18: Bedienleiste
- 20: Bedienfläche der Bedienleiste
- 22: außenliegendes Bedienfeld
- 24: Bedienfeld
- 26: mittleres Bedienfeld
- 28: Bedienfeld
- 30: außenliegendes Bedienfeld
- 32: Trägerelement
- 34: Schwenkachse des Trägerelements
- 36: Schwenkrichtungen
- 38: Seitenwände des Gehäuses
- 40: Schwenklagerböcke
- 42: Schwenkpositionssensor
- 44: Schwenkpositionssensor
- 46: Ende der Bedienleiste
- 48: Ende der Bedienleiste
- 50: Biegewelle, Kippachse
- 52: Kipperfassungssensor für die Bedienleiste
- 54: Kipperfassungssensor für die Bedienleiste
- 56: Biegesteg
- 58: Biegesteg
- 60: Auswerte- und Ansteuereinheit
- 62: Kippachsensensors
- 64: Torsionsfeder

## Patentansprüche

1. Bedieneinheit für ein elektrisches Gerät, insbesondere für eine Fahrzeugkomponente wie z.B. eine Heizungs-, Lüftungs- und/oder Klimaanlage, mit
- einem Gehäuse (12), das eine Vorderwand (14) aufweist,
- einer über die Vorderwand (14) vorstehenden Bedienleiste (18), die eine Bedienfläche (20) mit einer Vielzahl von in Längserstreckung der Bedienleiste (18) nebeneinander und mit zwischen zwei Enden der Bedienleiste (18) angeordneten Bedienfeldern (22,24,26,28,30) zum Auslösen unterschiedlicher Gerätefunktionen aufweist,
- einem in dem Gehäuse (12) angeordneten Trägerelement (32) für die Bedienleiste (18),
- wobei die Bedienleiste (18) an dem Trägerelement (32) um eine quer zur Längserstreckung der Bedienleiste (18) verlaufende Kippachse gelagert ist und
- wobei das Trägerelement (32) in mindestens einer Schwenkrichtung aus einer Ruheposition, in die das Trägerelement (32) elastisch vorgespannt ist, um eine parallel zur Längserstreckung der Bedienleiste (18) verlaufende Schwenkachse (34) in eine Schwenkposition schwenkbar ist,
- einem Schwenkpositionssensor (42,44) zur Erfassung der Schwenkposition des Trägerelements (32) bei einer Betätigung der Bedienleiste (18),
- zwei Kipperfassungssensoren (52,54) zur Erfassung einer Verkippung der Bedienleiste (18) um die Kippachse bei Betätigung der Bedienleiste (18) durch manuelles Andrücken gegen ein Bedienfeld (22,24, 26,28,30) der Bedienleiste (18),
- wobei die Kipperfassungssensoren (52,54) eine Bewegung der Enden der Bedienleiste (18) bei Betätigung derselben erfassen, und
- einer Auswerte- und Ansteuereinheit (60) zum Empfang der Signale des Schwenkpositionssensors (42,44) und der Kipperfassungssensoren (52,54) und zur anhand der Signale der Kipperfassungssensoren (52,54) erfolgenden Ermittlung desjenigen Bedienfeldes (22,24,26, 28,30), auf dem bei manueller Betätigung der Bedienleiste (18) der Finger einer Hand mit einer zur Einnahme der Schwenkposition des Trägerelements (32) erforderlichen Betätigungskraft anliegt, und zur Auslösung der dem ermittelten Bedienfeld (22,24,26,28,30) zugeordneten Gerätefunktion.

2. Bedieneinheit nach Anspruch 1, **dadurch gekennzeichnet, dass** die Bedienleiste (18) an ihren Enden mittels Biegestegen (56,58) mit dem Trägerelement (32) verbunden ist und dass die Kipperfassungssensoren (52,54) eine Verbiegung der Biegestege (56,58) beim Verkippen der Bedienleiste (18) um die Kippachse detektieren.

3. Bedieneinheit nach Anspruch 1 oder 2, **dadurch gekennzeichnet, dass** die Kippachse als elastische Torsionsachse ausgebildet ist.

4. Bedieneinheit nach einem der Ansprüche 1 bis 3, **gekennzeichnet durch** einen Kippachsensensor zur Erfassung einer Bewegung der Kippachse in einer sowohl zur Kippachse selbst als auch zur Schwenkachse (34) senkrecht verlaufenden Normal-Bewegungsrichtung.

5. Bedieneinheit nach Anspruch 3 und 4, **dadurch gekennzeichnet, dass** die Torsionsachse biegesteif hinsichtlich einer Verbiegung in Normal-Bewegungsrichtung ist.

6. Bedieneinheit nach einem der Ansprüche 2 bis 5, **dadurch gekennzeichnet, dass** die Torsionsachse als Verbindungssteg ausgebildet ist, der wie die Biegestege (56,58) zu einer gemeinsamen Seite von einem Quersteg absteht, wobei die Biegestege (56,68) und der Verbindungssteg an dem Trägerelement (32) fixiert sind und die Bedienleiste (18) tragen.

7. Bedieneinheit nach Anspruch 6, **dadurch gekennzeichnet, dass** der Verbindungssteg auf Grund seiner Geometrie, seines Materials und/oder der Position seiner Anbindung an das Trägerelement (32) und/oder an die Bedienleiste (18) steifer ausgebildet ist als die Biegestege (56,58) und/oder dass z.B. bei gleicher Geometrie und gleichem Material des Verbindungsstegs sowie der Biegestege (56,58) der Verbindungssteg kürzer ist als die Biegestege (56,58) und/oder eine kürzere freie Biegelänge aufweist als die Biegestege (56,58), und zwar insbesondere dadurch, dass der Verbindungssteg an einer ersten Anbindungsstelle von dem Trägerelement (32) und die Biegestege (56,58) an einer zweiten Anbindungsstelle von dem Trägerelement (32) abstehen, wobei die zweiten Anbindungsstellen von der Bedienleiste (18) weiter beabstandet sind als die erste Anbindungsstelle.

8. Bedieneinheit nach einem der Ansprüche 1 bis 7, **dadurch gekennzeichnet, dass** das Trägerelement (32) aus der Ruheposition in zwei entgegengesetzten Schwenkrichtungen und damit in zwei entgegengesetzte Schwenkpositionen schwenkbar ist und dass der Schwenkpositionssensor (42,44) die jeweils eingenommene Schwenkposition erfasst oder dass zwei Schwenkpositionssensoren (42,44) zur Erfassung jeweils einer anderen der beiden Schwenkpositionen vorgesehen sind.

9. Bedieneinheit nach Anspruch 8, **dadurch gekennzeichnet, dass** jeder Kipperfassungssensor (52,54) eine Bewegung des betreffenden Endes der Bedienleiste (18) und/oder ein auf das betreffende Ende der Bedienleiste (18) wirkendes Moment in jeder von zwei entgegengesetzten Bewegungsrichtungen erfasst.

10. Bedieneinheit nach Anspruch 9, **dadurch gekennzeichnet, dass** jeder Kipperfassungssensor (52,54) in einer Ruheposition der Bedienleiste (18), in der die Bedienleiste (18) nicht betätigt ist, eine Vorspannung des betreffenden Biegesteges (56,58) erfasst und dass die Bewegungsrichtung eines Endes der Bedienleiste (18) bei deren Betätigung anhand einer Vergrößerung oder einer Verkleinerung des Signals des Kipperfassungssensors (52,54), das dieser bei in Ruheposition befindlicher Bedienleiste (18) ausgibt, detektierbar ist.

## Claims

1. Operating unit for an electrical apparatus, in particular for a vehicle component such as, for example, a heating, ventilation and/or air conditioning installation, the operating unit being provided with
- a housing (12) having a front wall (14),
- an operating strip (18) projecting beyond the front wall (14), the operating strip having an operating surface (20) with a plurality of operating fields (22, 24, 26, 28, 30) for triggering different apparatus functions, the operating fields being arranged side by side in the longitudinal direction of the operating strip (18) and between two ends of the operating strip (18),
- a support element (32) for the operating strip (18), which is arranged in the housing (12),
- wherein the operating strip (18) is mounted on the support element (32) about a tilt axis that extends transversely to the longitudinal extension of the operating strip (18), and
- wherein the support element (32) is pivotable in at least one pivoting direction about a pivot axis (34) that extends parallel to the longitudinal extension of the operating strip (18) between a rest position into which the support element (32) is elastically prestressed and a pivot position,
- at least one pivot position sensor (42, 44) for detecting the pivot position of the support element (32) when the operating strip (18) is actuated,
- two tilt detection sensors (52, 54) for detecting a tilting of the operating strip (18) about the tilt axis when the operating strip (18) is actuated by manually pressing against an operating field (22, 24, 26, 28, 30) of the operating strip (18),
- wherein the tilt detection sensors (52, 54) detect a movement of the ends of the operating strip (18) when the same is actuated, and
- an evaluation and control unit (60) for receiving the signals of the pivot position sensor (42, 44) and the tilt detection sensors (52, 54) and for determining, on the basis of the signals emitted by the tilt detection sensors (52, 54), the operating field (22, 24, 26, 28, 30) on which, upon manual actuation of the operating strip (18), a finger of one hand is applied with an actuating force required for adopting the pivot position of the support element (32) and for triggering the apparatus function that is associated with the determined operating field (22, 24, 26, 28,30).

2. Operating unit of claim 1, **characterized in that** the operating strip (18) has its ends connected with the support element (32) via flexible webs (56, 58) and that the tilt detection sensors (52, 54) detect a bending of the flexible webs (56, 58) when the operating strip (18) is tilted about the tilt axis.

3. Operating unit of claim 1 or 2, **characterized in that** the tilt axis is formed as an elastic torsion axis.

4. Operating unit of one of claims 1 to 3, **characterized by** a tilt axis sensor for the detection of a movement of the tilt axis in a normal movement direction extending perpendicularly to the tilt axis itself, as well as to the pivot axis (34).

5. Operating unit of claims 3 and 4, **characterized in that** the tilt axis is flexurally rigid with respect to a bending in the normal movement direction.

6. Operating unit of one of claims 2 to 5, **characterized in that** the torsion axis is designed as a connecting web which, similar to the flexible webs (56, 58), protrudes to a common side from a transversal web, the flexible webs (56, 58) and the connecting web being fixed to the support element (32) and bear the operating strip (18).

7. Operating unit of claim 6, **characterized in that** for reasons of its geometry, its material and/or the position of its connection with the support element (32) and/or with the operating strip (18), the connecting rod is more rigid than the flexible webs (56, 58) and/or that if the connecting webs and the flexible webs (56, 58) e.g. have the same geometry and are made of the same material, the connecting web is shorter than the flexible webs (56, 58) and/or has a shorter free bending length than the flexible webs (56, 58), in particular due to the fact that the connecting web protrudes from the support element (32) at a first connection point and the flexible webs (56, 58) protrude from the support element (32) at a second connection point, the second connection points being spaced farther from the operating strip (18) than the first connection point.

8. Operating unit of one of claims 1 to 7, **characterized in that** the support element (32) is pivotable from the rest position in two opposite pivot directions and thus into two opposite pivot positions, and that the pivot position sensor (42, 44) detects the respective pivot position adopted, or that two pivot position sensors (42, 44) are provided for the detection of a respective other one of the two pivot positions.

9. Operating unit of claim 8, **characterized in that** each tilt detection sensor (52, 54) detects a movement of the respective end of the operating strip (18) and/or a moment acting on the respective end of the operating strip (18) in each of two opposite movement directions.

10. Operating unit of claim 9, **characterized in that**, in a rest position of the operating strip (18) in which the operating strip (18) is not actuated, every tilt detection sensor (52, 54) detects a prestressing of the respective flexible web (56, 58), and that the movement direction of an end of the operating strip (18) may be detected based on an increase or decrease of the signal of the tilt detection sensor (52, 54) outputted by this sensor when the operating strip (18) is in the rest position.

## Revendications

1. Unité de commande destinée à un appareil électrique, notamment un composant de véhicule comme par exemple un système de chauffage, de ventilation et/ou de climatisation, comprenant
- un boîtier (12) qui comporte une paroi avant (14),
- une barre de commande (18) qui fait saillie au-dessus de la paroi avant (14) et qui comporte une surface de commande (20) pourvue d'une pluralité de zones de commande (22, 24, 26, 28, 30) disposées les unes à côté des autres suivant l'extension longitudinale de la barre de commande (18) et entre deux extrémités de la barre de commande (18) et destinées à déclencher différentes fonctions de l'appareil,
- un élément porteur (32) disposé dans le boîtier (12) et destiné à la barre de commande (18),
- la barre de commande (18) étant montée sur l'élément porteur (32) autour d'un axe d'inclinaison s'étendant transversalement à l'extension longitudinale de la barre de commande (18) et
- l'élément porteur (32) peut pivoter dans au moins un sens de pivotement depuis une position de repos, dans laquelle l'élément porteur (32) est précontraint élastiquement, jusque dans une position de pivotement autour d'un axe de pivotement (34) s'étendant parallèlement à l'extension longitudinale de la barre de commande (18),
- un capteur de position de pivotement (42, 44) destiné à détecter la position de pivotement de l'élément porteur (32) lors de l'actionnement de la barre de commande (18),
- deux capteurs de détection d'inclinaison (52, 54) destiné à détecter l'inclinaison de la barre de commande (18) autour de l'axe d'inclinaison lors de l'actionnement de la barre de commande (18) par pression manuelle sur une zone de commande (22, 24, 26, 28, 30) de la barre de commande (18),
- les capteurs de détection d'inclinaison (52, 54) détectant le mouvement des extrémités de la barre de commande (18) lors de actionnement de celle-ci, et
- une unité d'évaluation et de commande (60) destinée à recevoir les signaux provenant du capteur de position de pivotement (42, 44) et des capteurs de détection d'inclinaison (52, 54) et à déterminer, sur la base des signaux provenant des capteurs de détection d'inclinaison (52, 54), la zone de commande (22, 24, 26, 28, 30) sur laquelle le doigt d'une main est appliqué, lors d'un actionnement manuel de la barre de commande (18), avec une force d'actionnement requise pour que l'élément porteur (32) prenne la position de pivotement, et à déclencher la fonction d'appareil associée à la zone de commande déterminée (22, 24, 26, 28, 30).

2. Unité de commande selon la revendication 1, **caractérisée en ce que** la barre de commande (18) est reliée à ses extrémités à l'élément porteur (32) au moyen de nervures flexibles (56, 58) et **en ce que** les capteurs de détection d'inclinaison (52, 54) détectent la flexion des nervures flexibles (56, 58) lors de l'inclinaison de la barre de commande (18) autour de l'axe d'inclinaison.

3. Unité de commande selon la revendication 1 ou 2, **caractérisée en ce que** l'axe d'inclinaison est conçu comme un axe de torsion élastique.

4. Unité de commande selon l'une des revendications 1 à 3, **caractérisée par** un capteur d'axe d'inclinaison destiné à détecter un mouvement de l'axe d'inclinaison dans une direction de mouvement normale perpendiculaire à la fois à l'axe d'inclinaison lui-même et à l'axe de pivotement (34).

5. Unité de commande selon les revendications 3 et 4, **caractérisée en ce que** l'axe de torsion est rigide en flexion par rapport à une flexion dans la direction de mouvement normale.

6. Unité de commande selon l'une des revendications 2 à 5, **caractérisée en ce que** l'axe de torsion est réalisé sous la forme d'une nervure de liaison qui s'étend, comme les nervures flexibles (56, 58) vers un côté commun depuis une nervure transversale, les nervures flexibles (56, 68) et La nervure de liaison étant fixées à l'élément porteur (32) et portant la barre de commande (18).

7. Unité de commande selon la revendication 6, **caractérisée en ce que** la nervure de liaison est conçue, en raison de sa géométrie, de sa matière et/ou de la position de sa liaison à l'élément porteur (32) et/ou à la barre de commande (18), pour être plus rigide que les nervures flexibles (56, 58) et/ou **en ce que**, par exemple pour une même géométrie et une même matière de la nervure de liaison et des nervures flexibles (56, 58), la nervure de liaison est plus courte que les nervures flexibles (56, 58) et/ou a une longueur de flexion libre plus courte que celle des nervures flexibles (56, 58), notamment en raison du fait que la nervure de liaison s'étende depuis l'élément porteur (32) à un premier point de liaison et que les nervures flexibles (56, 58) s'étendent depuis l'élément porteur (32) à un deuxième point de liaison, les deuxièmes points de liaison sont davantage espacés de la barre de commande (18) que le premier point de liaison.

8. Unité de commande selon l'une des revendications 1 à 7, **caractérisée en ce que** l'élément porteur (32) peut pivoter de la position de repos dans deux directions de pivotement opposées, et donc dans deux positions de pivotement opposées et **en ce que** le capteur de position de pivotement (42, 44) détecte la position de pivotement respectivement occupée, ou **en ce que** deux capteurs de position de pivotement (42, 44) sont prévus pour détecter à chaque fois une position différente des deux positions de pivotement.

9. Unité de commande selon la revendication 8, **caractérisée en ce que** chaque capteur de détection d'inclinaison (52, 54) détecte un mouvement de l'extrémité respective de la barre de commande (18) et/ou un couple, agissant à l'extrémité respective de la barre de commande, dans chacune des directions de mouvement opposées.

10. Unité de commande selon la revendication 9, **caractérisée en ce que** chaque capteur de détection d'inclinaison (52, 54) détecte, dans une position de repos de la barre de commande (18) dans laquelle la barre de commande (18) n'est pas actionnée, une précontrainte de la nervure flexible respective (56, 58) et **en ce que** la direction de déplacement d'une extrémité de la barre de commande (18) peut être détectée lors de son actionnement sur la base d'une augmentation ou d'une diminution du signal du capteur de détection d'inclinaison (52, 54) que celui-ci délivre lorsque la barre de commande (18) est en position de repos.
